# EUROPEAN PATENT APPLICATION

(11) **EP 2 581 639 A1**
(43) Date of publication of application: **17.04.2013**
(21) Application number: 12188096.7
(22) Date of filing: 11.10.2012
(51) Int. Cl.: F21K 99/00, F21V 9/16, F21V 29/00, F21V 3/04, F21Y 101/02

(54) **LED lamp having two layers of fluorescent powder**

(30) Priority: 14.10.2011 CN 201120395577 U
(71) Applicant: Cheng, Yung Pun, Kowloon, Hong Kong (CN)
(72) Inventor: Cheng, Yung Pun, Kowloon, Hong Kong (CN)
(74) Representative: Gaunt, Thomas Derrick

(57) **Abstract**

An LED lamp having two layers of fluorescent powder, wherein a blue light of 400-530 nm emitted by a blue light LED chip (2) first irradiates on an inner layer (3) of silicate fluorescent powder to excite a light of a higher wavelength which is then emitted to an outer layer (4) of YAG fluorescent powder, so as to obtain an ideal warm white light. On one hand, the yellow light excited by the silicate fluorescent powder re-excites YAG fluorescent powder to obtain a warm white light having a higher colour rendering index; on the other hand, a light source with an area several times greater than that of the original chip obtained by exciting the inner layer (3) of silicate fluorescent powder can re-excite the YAG fluorescent powder to multiply the excitation effect.

## Description

### TECHNICAL FIELD

This invention generally relates to a white light LED lighting device, more particularly to a LED light emitting a desirable warm white light by double excitation of two fluorescent powder layers.

### BACKGROUND

With technology development, more and more white light LED lamps are utilized in the common lighting field. Compared with an incandescent lamp, a white light LED lamp has advantages of less bulk, less heat generation, less power consumption, longer lifetime, faster response speed, and more environment friendliness, etc., therefore it is more promising.

Currently, a white light with various colour rendering index is generally generated by combination of a plurality of monochromatic LED chips or combination of monochromatic LED chips with fluorescent powder. For example, a white light can be generated by combination of red light chips, blue light chips and green light chips, or a blue light chip coated with yellow fluorescent powder (e.g., YAG fluorescent powder), wherein the former is difficult to be popularised due to a high manufacturing cost, while the latter is disadvantageous due to the low colour rendering index of the white light and the fluorescent powder's susceptibility to aging. Practices show that no ideal warm white light can be excited by solely utilizing YAG fluorescent powder till present (the excited light has a colour rendering index of only about 70), although it has been employed for almost 20 years.

In addition, currently, white light is usually obtained by using LED chip with a less area to directly excite the fluorescent powder coated onto the surface or outer casing, which limits the effective lighting area and light intensity of the LED lamp.

Therefore, there is a need for new LED lighting device which is able to prominently improve the colour rendering index of white light and increase lighting area as well as light intensity.

### SUMMARY

According to the present invention, a LED lamp having two layers of fluorescent powder is provided, which is **characterized in that** it comprises: blue light LED chips; an inner cover which contains silicate fluorescent powder and covers the blue light LED chips; and an outer cover which contains YAG or silicate fluorescent power and covers outside of the inner layer.

In a further embodiment, both the inner and outer covers are self-supported.

In a further embodiment, both the inner and outer covers are casings formed by mixing fluorescent powder and transparent moulding materials.

In a further embodiment, transparent cooling liquid is filled between the inner and outer covers as well as inside the inner cover.

In a further embodiment, the LED lamp further comprises a transparent casing, and the inner and outer covers are fluorescent powder layer coated on the inner surface and the outer surface of the transparent casing, respectively.

In a further embodiment, the transparent casing is made of glass or transparent polymer.

In a further embodiment, the transparent casing is 1~3 mm in thickness.

In a further embodiment, transparent cooling liquid is filled inside the transparent casing.

The present invention has the following advantage: an ideal warm white light with a high colour rendering index can be obtained by double excitation, that is, the blue light of 400-530 nm emitted by the LED chip irradiates on the silicate fluorescent powder to excite higher wavelength light, and the higher wavelength light in turn irradiates on further outer silicate fluorescent powder to re-excite. In addition, the present invention utilizes a LED chip of a very small area to excite silicate fluorescent powder cover of tens of times of that area, so as to obtain a light source having light intensity several times greater than that of the original chip, and this light source re-excites the outer YAG fluorescent powder or silicate fluorescent powder cover to obtain a multiplied excitation effect.

### BRIEF DESCRIPTION OF THE DRAWINGS

Fig.1 schematically shows a first embodiment of the LED lamp according to the present invention.

Fig.2 schematically shows a second embodiment of the LED lamp according to the present invention.

### DETAILED DESCRIPTION

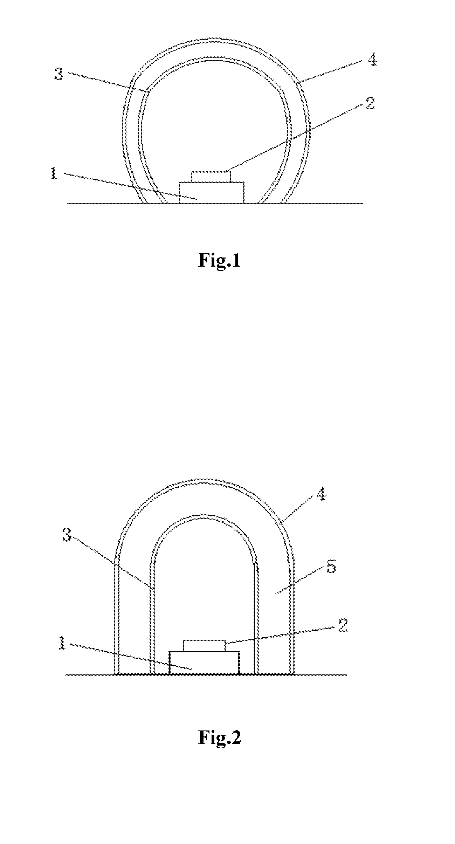

Hereinafter the preferred embodiments of the present invention will be described in connection with the Drawings. Referring to Fig.1 first, the figure schematically shows one embodiment of the LED lamp according to the present invention. The LED lamp comprises one or more blue light LED chips 2 arranged on a support 1 and two covers 3 and 4. These chips can be adhered to the support through transparent die-attaching adhesive or other ways. The arrangement manner of these chips can be determined according to the practical requirement, for example, these chips can be arranged in one or two dimensions, or in concentric circles for uniformly lighting. Of course, other arrangement manner is also conceivable. These chips can be fixed to the support by conventional setup ways or vertically set up together with support. When the diode is turned on, the front face of these LED chips on the vertical transparent support normally radiates, meanwhile the bottom of these LED chip can also radiate more brighter light through the transparent support, therefore LED light extraction can be improved by eliminating the limitation that supply wires prevent the LED from demonstrating its brightest face due to current packaging technology.

The LED lamp according to the present invention employs two kinds of fluorescent powder, i.e., YAG fluorescent powder and silicate fluorescent powder, to obtain ideal warm white light. As a most commonly used fluorescent powder of the art, YAG fluorescent powder mainly consists of aluminium oxide and yttrium oxide and a small amount of cerium oxide, and can be added with a small amount of gadolinium and potassium, etc.. YAG fluorescent powder can generate yellow light when excited by blue light, and white light can be obtained by mixing the yellow light and the blue light. Silicate fluorescent powder is one utilizing silicon dioxide, strontium carbonate, and barium carbonate as the base material, and emits light with wavelength adjustable between 507 nm ~ 610 nm. The silicate fluorescent powder described herein may comprise green powder (having a component of barium (Ba) 0.8 strontium (Sr) 0.2 silicon (Si), oxygen (O), europium (Eu) 0.02) and red powder (having a component of barium (Ba) 0.05, strontium (Sr) 2.9, silicon (Si), magnesium (Mg) 0.05, oxygen (O), europium (Eu) 0.02). Silicate fluorescent powder has advantages in substantially absorbing the ultraviolet light, the near ultraviolet light, and the blue light, and emitting light covering a wide wavelength range, which provides good emission effect from green light to orange light and capability for users to adjusting spectrum as desired.

Specifically, in the embodiment shown in Fig.1, the inner cover 3 covering outside the blue light LED chip 2 contains silicate fluorescent powder, and the outer cover 4 contains YAG fluorescent powder and optional silicate fluorescent powder. In normal operation, when being powered, the LED chip 2 emits blue light with wavelength between 400-530 nm which irradiates on the silicate fluorescent powder of the inner cover. The silicate fluorescent powder is excited and converts the blue light into a light of wavelength between 402-550 nm(the waveband is increased by 0.5%-10%). The light of higher wavelength further irradiates onto the YAG fluorescent powder or silicate fluorescent powder of the outer cover and is converted into a light of another wavelength (e.g., yellow light). The excited lights and the transmitted lights of various wavelengths are mixed into warm white light with a colour rendering index of more than 80.

In another aspect, the inner cover 3 containing silicate fluorescent powder together with LED chips 2 can be regarded as a special illuminant, which utilizes a LED chip of very small area to excite a silicate fluorescent powder cover with an area tens of times greater than that of the chip, so as to obtain a light source of an effective lighting area several times greater than the original wafer, wherein the light from the light source re-excites the outside YAG fluorescent powder or silicate fluorescent powder cover to realize a multiplied excitation effect.

In this embodiment, both the inner cover 3 and the outer cover 4 are self-supported, that is to say, both of which are independent covers with a distance there between, for example, 0.1~3 mm. To this end, these casing can be made of a mixture of fluorescent powder and transparent moulding materials, for example, fluorescent powder and transparent polymer or glass can be mixed by heating and moulded. It may be hollow between the inner cover 3 and the outer cover 4, and it may also be hollow inside the inner cover 3, but preferably, transparent cooling liquid can be filled therein to expedite dissipating the heat generated by the LED chips.

Contrast to the embodiment shown in Fig.1, the LED lamp further comprises a transparent casing 5, wherein the inner cover 3 and the outer cover 4 respectively are fluorescent powder layer coated onto the inner surface and outer surface of the transparent casing 5. The transparent casing 5 can be made of transparent materials, such as glass or polymer. The transparent casing may have a thickness of 1~3 mm, and the coated fluorescent powder layers may have a thickness between 0.1~1.5 mm. Similarly, as an alternative, transparent cooling liquid can be filled into the cavity formed in the casing 5 to expedite the heat dissipation of the LED chip.

Although Fig. 1 shows a LED lamp of circular or oval profile and Fig. 2 shows a cylindrical LED lamp with a convex crest, the present invention is not limited therein, and other shapes such as a square LED lamp is also conceivable. In addition, it is apparent to those skilled in the art that the embodiment of Fig. 1 can advantageously employ the shape shown in Fig. 2, that is to say, the inner cover 3 and outer cover 4 shown in Fig. 1 can be designed as nested test tubes to facilitate manufacture and assembly.

Although the present invention has been described in details in connection with the embodiments shown in the figures, it is to be understood by those skilled in the art that other embodiments will provide the same results. Variations and modifications to the present invention are obvious to those skilled in the art and in the scope of the present invention.

## Claims

1. A LED lamp having two layers of fluorescent powder, **characterized in that** the lamp comprises:
blue light LED chips;
an inner cover which contains silicate fluorescent powder and covers the blue light LED chips; and
an outer cover which contains YAG or silicate fluorescent power and covers outside of the inner layer.

2. The LED lamp according to Claim 1, **characterized in that** both the inner and outer covers are self-supported.

3. The LED lamp according to Claim 2, **characterized in that** both the inner and outer covers are casings formed by mixing fluorescent powder and transparent polymer or glass.

4. The LED lamp according to Claim 2 or 3, **characterized in that** transparent cooling liquid is filled between the inner and outer covers as well as inside the inner cover.

5. The LED lamp according to Claim 1, **characterized in that** the LED lamp further comprises a transparent casing, and the inner and outer covers are fluorescent powder layer coated on the inner surface and the outer surface of the transparent casing, respectively.

6. The LED lamp according to Claim 5, **characterized in that** the transparent casing is made of glass or transparent polymer.

7. The LED lamp according to Claim 5, **characterized in that** the transparent casing is 1~3 mm in thickness.

8. The LED lamp according to any one of Claims 5-7, **characterized in that** transparent cooling liquid is filled inside the transparent casing.
